# EUROPÄISCHE PATENTANMELDUNG

(11) **EP 4 246 814 A1**
(43) Veröffentlichungstag der Anmeldung: **20.09.2023**
(21) Anmeldenummer: 22162657.5
(22) Anmeldetag: 17.03.2022
(51) Int. Cl.: H03M 7/30, G01R 15/14

(54) **VORRICHTUNG UND VERFAHREN ZUR ÜBERTRAGUNG VON SENSORDATEN, VORRICHTUNG ZUR VERARBEITUNG VON KOMPRIMIERTEN SENSORDATEN UND MESSSYSTEM**

(71) Anmelder: Siemens Aktiengesellschaft, 80333 München (DE)
(72) Erfinder: Jäger, Michael, 81541 München (DE); Salecker, Jürgen, 81827 München (DE)
(74) Vertreter: Siemens Patent Attorneys

(57) **Zusammenfassung**

Die Erfindung betrifft eine Kompression sowie Übertragung von Sensordaten, insbesondere von Sensordaten für sich kontinuierlich ändernde Sensorwerte. Hierzu wird für die Kompression der Sensordaten einen verlustfreien Kompressionsalgorithmus aus dem Bereich der Streaming- oder Audiosignale genutzt.

## Beschreibung

### Technisches Gebiet

Die vorliegende Erfindung betrifft eine Vorrichtung und ein Verfahren zur Übertragung von Sensordaten, eine Vorrichtung zur Verarbeitung von komprimierten Sensordaten sowie ein Messsystem.

### Stand der Technik

Obwohl die vorliegende Erfindung nachfolgend in Zusammenhang mit einem Sensor zur Erfassung von elektrischen Strömen geschrieben wird, ist die Erfindung nicht hierauf beschränkt. Vielmehr kann die Erfindung auf beliebige Sensorsysteme angewendet werden, bei welchen die Sensoren physikalische Größen erfassen, die kontinuierlich einer dynamischen Veränderung unterworfen ist.

Sensoren erfassen in der Regel eine physikalische Größe und liefern ein zu dieser physikalischen Größe korrespondierendes Ausgangssignal. Hierbei können die Informationen der überwachten physikalischen Größe beispielsweise als digitale Daten bereitgestellt werden. Unterliegt die zu überwachende physikalische Größe dabei einer dynamischen Änderung, so kann es erforderlich sein, die Erfassung mit einer ausreichend hohen Datenrate auszuführen.

Eine solche digitale Erfassung von Sensorsignalen mit einer hohen Abtastrate führt jedoch zu einer hohen Menge an Daten. Diese große Menge an Sensordaten muss zunächst von der Datenquelle zu einer Bearbeitungseinrichtung übertragen werden. Darüber hinaus ist es in vielen Fällen erforderlich, die gewonnenen Sensordaten für eine spätere Auswertung oder Weiterverarbeitung zunächst zu speichern.

Die dabei anfallende Datenmenge der Sensordaten stellt sowohl für die Übertragung als auch die Speicherung der Sensordaten eine Herausforderung dar. Insbesondere sich kontinuierlich ändernden Größen, wie beispielsweise elektrische Ströme oder daraus abgeleitete Werte wie eine Energieverbrauch, stellen für eine Datenreduktion bzw. Kompression der Daten eine Herausforderung dar.

### Offenbarung der Erfindung

Vor diesem Hintergrund ist es eine Aufgabe der vorliegenden Erfindung, einen geeigneten und effizienten Ansatz zur Übertragung und Speicherung von Sensordaten, insbesondere Sensordaten von sich kontinuierlich ändernden Größen, zu schaffen.

Hierzu offenbart die vorliegende Erfindung eine Vorrichtung und ein Verfahren zur Übertragung von Sensordaten, eine Vorrichtung zur Verarbeitung von komprimierten Sensordaten sowie ein Messsystem mit den Merkmalen der unabhängigen Patentansprüche. Weitere vorteilhafte Ausführungsformen sind Gegenstand der abhängigen Patentansprüche.

Gemäß einem ersten Aspekt ist eine Vorrichtung zu Übertragung von Sensordaten vorgesehen. Die Vorrichtung umfasst eine Komprimierungseinrichtung und eine Übertragungseinrichtung. Die Komprimierungseinrichtung ist dazu ausgelegt, die Sensordaten von mindestens einem Sensor zu komprimieren. Insbesondere werden die Sensordaten hierbei unter Verwendung eines verlustfreien Kompressionsalgorithmus komprimiert. Der verlustfrei Kompressionsalgorithmus ist dazu ausgelegt, einen kontinuierlichen Datenstrom verlustfrei zu komprimieren. Die Übertragungseinrichtung ist dazu ausgelegt, die komprimierten Sensordaten auszugeben.

Gemäß einem weiteren Aspekt ist eine Vorrichtung zur Verarbeitung von komprimierten Sensordaten vorgesehen. Die Vorrichtung zur Verarbeitung der komponierten Sensordaten umfasst eine Dekomprimierungseinrichtung. Die Dekomprimierungseinrichtung ist dazu ausgelegt, verlustfrei komprimierte Sensordaten zu dekomprimieren. Die Dekomprimierung erfolgt unter Verwendung eines verlustfreien Dekompressionsalgorithmus. Dieser Dekompressionsalgorithmus ist dazu ausgelegt, Daten aus einem verlustfrei komprimierten kontinuierlichen Datenstrom zu dekomprimieren.

Gemäß einem weiteren Aspekt ist ein Messsystem vorgesehen. Das Messsystem umfasst mindestens einen Sensor und eine erfindungsgemäße Vorrichtung zur Übertragung von Sensordaten. Der mindestens eine Sensor ist dazu ausgelegt, Sensordaten bereitzustellen, die zu einer sensorisch erfassten physikalischen Größe korrespondieren.

Gemäß noch einem weiteren Aspekt ist ein Verfahren zu Übertragung von Sensordaten vorgesehen. Das Verfahren umfasst einen Schritt zum Komprimieren von Sensordaten von mindestens einem Sensor. Das Komprimieren erfolgt unter Verwendung eines verlustfreien Kompressionsalgorithmus, wobei der verlustfreie Kompressionsalgorithmus dazu ausgelegt ist, einen kontinuierlichen Datenstrom verlustfrei zu komprimieren. Ferner umfasst das Verfahren einen Schritt zum Ausgeben der komprimierten Sensordaten.

Die vorliegende Erfindung beruht auf der Erkenntnis, dass es bei einer kontinuierlichen sensorischen Erfassung zu einem hohen Aufkommen von Sensordaten kommen kann. Hierbei stellt sowohl Übertragung als auch die Speicherung dieser großen Menge an Sensordaten eine nicht zu vernachlässigende Herausforderung dar. Daher ist es wünschenswert, die anfallenden Sensordaten effizient zu komprimieren.

Für die Kompression von Daten wird grundsätzlich zwischen verlustbehafteten und verlustfreien Kompressionsverfahren unterschieden. Hierbei führt die Gruppe der verlustbehafteten Kompressionsverfahren jedoch zwangsläufig auch zu einem Informationsverlust. Derartige verlustbehaftete Kompressionsverfahren sind daher für eine aussagekräftige Weiterverarbeitung von Sensordaten in der Regel nicht oder nur sehr eingeschränkt geeignet

Verlustfreie Kompressionsverfahren sind in großem Maße in Zusammenhang mit der Komprimierung von Dateien bekannt. Bei diesen Ansätzen erfolgt die Komprimierung einer bekannten abgeschlossenen Menge von Daten, vorzugsweise unter Berücksichtigung der unterschiedlichen Häufigkeit der einzelnen Datenelemente. Da es sich jedoch bei einem kontinuierlichen Datenstrom von den Sensordaten um keine abgeschlossene Menge von Daten handelt, und darüber hinaus auch die zu überwachende Sensorgröße über die Zeit hinweg kontinuierlich über den gesamten Wertebereich schwanken kann, sind auch solche konventionellen verlustfreien Kompressionsalgorithmen, wie sie für die Dateikompression eingesetzt werden, für Anwendungen von sich kontinuierlich ändernden Sensordaten nicht oder zumindest nur sehr eingeschränkt geeignet.

Es ist daher eine Idee der vorliegenden Erfindung, für die Übertragung und Speicherung von Sensordaten auf Kompressionsalgorithmen zurückzugreifen, die auch bei sich kontinuierlich ändernden Sensorsignalen eine effektive Komprimierung erlauben, d. h. eine hohe Kompressionsrate erzielen, ohne hierbei einen Informationsverlust in Kauf nehmen zu müssen, wie dies bei verlustbehafteten Verfahren der Fall ist.

Hierzu ist es ein erfindungsgemäßer Ansatz, als Kompressionsverfahren einen Kompressionsalgorithmus einzusetzen, wie er bisher nur für Streaming-Anwendungen, beispielsweise für Audiodaten o. ä., eingesetzt wird. Entsprechend wird für den kontinuierlichen Datenstrom der Sensordaten ein verlustfreies Kompressionsverfahren für Streaming-Dienste, insbesondere ein verlustfreier Kompressionsalgorithmus für Audiodaten eingesetzt.

Dabei liegt der vorliegenden Erfindung die Erkenntnis zugrunde, dass sich kontinuierlich ändernde Sensordaten eine sehr große Ähnlichkeit mit Audiodaten aufweisen. Darüber hinaus kann auch in vielen Anwendungsfällen die Abtastrate für Erfassung von Sensorsignalen im Bereich einer Abtastrate liegen, wie sie für die Abtastung von Audiosignalen verwendet wird. Daher beruht erfindungsgemäße Einsatz von verlustfreien Streaming-Kompressionsverfahren, insbesondere Kompressionsverfahren für eine verlustfreie Kompression von Audiodaten auf der Feststellung, dass Sensordaten von sich kontinuierlich ändernden Signalen eine große Ähnlichkeit mit Audiosignalen haben und daher die zunächst fachfremd anmutenden Kompressionsalgorithmen für Audiosignale sehr gut für derartige Anwendungsfälle sich eignen.

Damit können derartige verlustfreie Streaming- bzw. Audio-Kompressionsalgorithmen sehr gut für eine effiziente Datenreduktion von Sensordaten für sich kontinuierlich ändernde Größen, wie beispielsweise einen elektrischen Strom oder eine Energieverbrauch eingesetzt werden. Aber auch andere sensorisch erfasste Größen, welche sich kontinuierlich ändern und nicht regelmäßig signifikante stationäre oder zumindest quasi stationäre Phasen aufweisen, können durch derartige Algorithmen sehr effizient komprimiert werden.

Gemäß einer Ausführungsform umfasst der Kompressionsalgorithmus einen Algorithmus zur verlustfreien Kompression von Audiodaten. Insbesondere kann der Kompressionsalgorithmus einen Free Lossless Audio Codec (FLAC) umfassen. Aber auch andere verlustfrei Kompressionsverfahren für Streaming Daten, insbesondere Audiodaten, sind ebenfalls möglich. Beispielsweise kann als verlustfreies Kompressionsverfahren auch Adaptive TRansform Acoustic Coding (ATRAC), MPEG-4 Audio Lossless Coding (ALS), MPEG-1 Audio Layer 3 (mp3HD), oder ein beliebiger anderer verlustfreier Audio-Kompressionsalgorithmus angewendet werden.

Gemäß einer Ausführungsform sind die Sensoren, welche die Sensordaten bereitstellen, dazu ausgelegt, einen elektrischen Strom oder eine elektrische Leistung zu erfassen. Sensorsignale von Strom- oder Leistungssensoren können je nach Anwendungsfall ein Signal überwachen, welches kontinuierlich einer Veränderung unterworfen ist. Da derartige Signale je nach Anwendungsfall keine oder nur geringe Anteile einer stationären Phase aufweisen, sind hierfür Kompressionsalgorithmen, die zunächst eine Anzahl von gleicher Datenelementen in einer abgeschlossenen Datenmenge analysieren, weniger geeignet. Dagegen führen erfindungsgemäß eingesetzten Kompressionsalgorithmen für Streaming-Daten, insbesondere Audiosignale, bei derartigen Strom- oder Spannungsmessungen zu sehr guten Kompressionsraten. Somit kann beispielsweise die Effizienz gesteigert werden und die erforderliche Bandbreite für die Datenübertragung kann minimiert werden.

Gemäß einer Ausführungsform sind die eingesetzten Sensoren dazu ausgelegt, die erfasste physikalische Grüße mit einer Abtastrate von mindesten 1 Kilohertz abzutasten. Insbesondere sind Abtastraten von 20 kHz oder gegebenenfalls auch mehr möglich, um damit Oberschwingungsanalysen durchzuführen. Beispielsweise kann die Abtastrate zur Erfassung der physikalischen Größe in einem Bereich liegen, welcher einer Abtastrate von Audiosignalen entspricht. Hierdurch ergibt sich eine besonders gute Übereinstimmung der gewonnenen Sensordaten mit Audiosignalen, sodass die Anwendung von Audio-Kompressionsalgorithmus für die Kompression der Sensordaten sehr einfach und effizient gestaltet werden kann.

Gemäß einer Ausführungsform umfasst das Messsystem eine Aggregationseinrichtung. Die Aggregationseinrichtung kann dazu ausgelegt sein, mehrere komprimierte Datenströme zu bündeln und weiterzuleiten. Alternativ ist es auch möglich, zunächst mehrere unkomprimierte Datenströme von Sensordaten zu einem gemeinsamen Datenstrom zu kombinieren und anschließend diesen Datenstrom zu komprimieren. Auf diese Weise kann eine effiziente Übertragung der gewonnenen Sensordaten zu einer Empfangseinrichtung erreicht werden.

Analog zu der Komprimierung der Sensordaten mittels eines verlustfreien Kompressionsalgorithmus für Streaming- bzw. Audiodaten kann auf der Empfangsseite eine hierzu korrespondierende Dekomprimierung der komprimierten Sensordaten vorgesehen sein. Hierbei können die empfangenen Sensordaten entweder direkt nach dem Empfang unmittelbar dekomprimiert werden. Zusätzlich oder alternativ können die empfangenen komprimierten Daten zunächst in einer Speichereinrichtung gespeichert werden und für eine spätere Analyse oder Weiterverarbeitung bereitgestellt werden.

Durch eine erfindungsgemäße Kompression der Sensordaten mittels eines Streaming- oder Audio-Kompressionsalgorithmus kann somit insbesondere für kontinuierlich schwankende Sensorwerte eine einfache und effiziente Datenkompression erzielt werden. Die erfindungsgemäße Idee beruht hierbei darauf, dass gerade kontinuierlich ändernde Sensordaten, beispielsweise von Strom- oder Leistungssensoren, eine große Ähnlichkeit mit Audiosignalen, wie Musik oder Sprache, aufweisen können. Daher können die bereits existierenden Kompressionsalgorithmen für derartige Audiosignale auch für kontinuierlich schwankende Sensordaten eingesetzt werden. Dabei kann durch die Verwendung derartiger Streaming- oder Audiokompressionsverfahren die Effizienz bzw. Kompressionsrate im Vergleich zu Kompressionsverfahren für abgeschlossene Datenmengen wie z.B. ZIP o.ä. gesteigert werden. Durch die Wahl von verlustfreien Kompressionsverfahren kann darüber hinaus gewährleistet werden, dass auf der Empfangsseite die dekomprimierten Daten vollständig den ursprünglichen Sensordaten entsprechen.

Die obigen Ausgestaltungen und Weiterbildungen lassen sich, soweit sinnvoll, beliebig miteinander kombinieren. Weitere Ausgestaltungen, Weiterbildungen und Implementierungen der Erfindung umfassen auch nicht explizit genannte Kombinationen von zuvor oder im Folgenden bezüglich den Ausführungsbeispielen beschriebenen Merkmalen der Erfindung. Insbesondere wird der Fachmann auch Einzelaspekte als Verbesserungen oder Ergänzungen zu den jeweiligen Grundformen der Erfindung hinzufügen.

### Kurze Beschreibung der Zeichnungen

Weitere Merkmale und Vorteile der Erfindung werden nachfolgend anhand der Figuren erläutert. Dabei zeigen:
Fig. 1: eine schematische Darstellung eines Blockschaubilds für ein Messsystem mit einer Vorrichtung zur Übertragung von Sensordaten gemäß einer Ausführungsform;
Fig. 2: eine schematische Darstellung einer Vorrichtung zur Übertragung von Sensordaten gemäß einer Ausführungsform;
Fig. 3: eine schematische Darstellung eines Blockschaubilds für ein Messsystem mit einer Vorrichtung zur Übertragung von Sensordaten gemäß einer weiteren Ausführungsform; und
Fig. 4: ein Ablaufdiagramm, wie es einem Verfahren zur Übertragung von Sensordaten gemäß einer Ausführungsform zugrunde liegt.

### Ausführungsformen

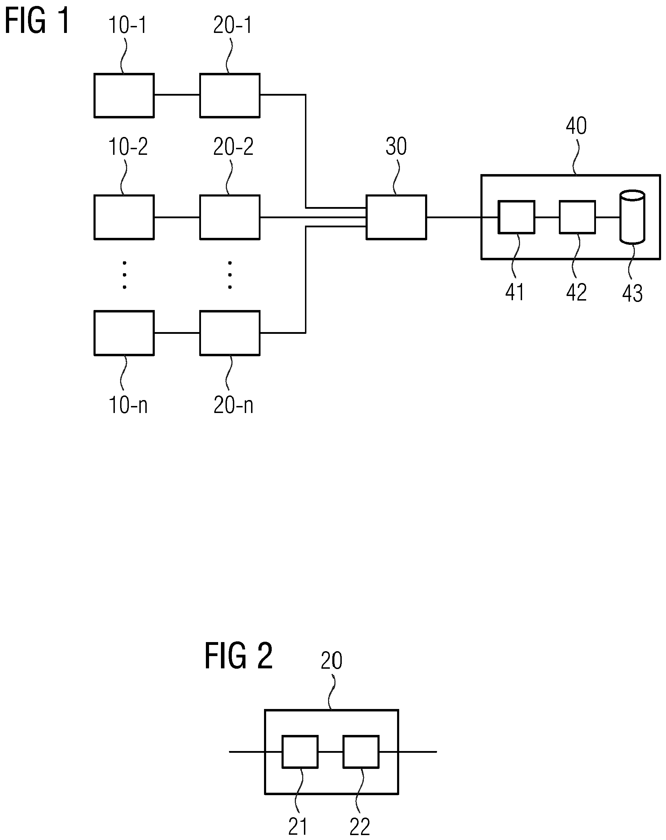

Figur 1 zeigt eine schematische Darstellung eines Blockschaubildes eines Messsystems 1 gemäß einer Ausführungsform. Das Messsystem kann einen oder mehrere Sensoren 10-i umfassen. Beispielsweise kann es sich bei diesen Sensoren 10-i um Sensoren handeln, welche einen elektrischen Strom oder eine elektrische Spannung erfassen. Zum Beispiel kann auf diese Weise auch aus Strom und Spannung der Energieverbrauch eines elektrischen Verbrauchers erfasst werden. Auch kann durch entsprechende Sensoren 10-i zum Beispiel Strom, Spannung oder Energieverbrauch an einer Übergabestelle, zum Beispiel an einem Hausanschluss o. ä., erfasst werden.

Die Sensoren 10-i liefern hierbei ein zu der jeweils erfassten physikalischen Größe korrespondierendes Ausgangssignal. Bei diesem Ausgangssignal kann es sich beispielsweise um einen digitalen Datenstrom handeln, welcher digitale Daten erfasst, die zu der erfassten physikalischen Größe korrespondieren. Dabei können die physikalische Größe bzw. ein hierzu korrespondierendes analoges Signal mit einer vorgegebenen Abtastrate und einer vorgegebenen Auflösung abgetastet werden. Beispielsweise sind hierzu Abtastrate von 1 kHz und mehr, insbesondere 20 kHz und mehr möglich.

Die Sensoren 10-i können insbesondere auch physikalische Größen überwachen, welche sich über einen längeren Zeitraum hinweg dynamisch ändern. In einem solchen Fall weist das hierzu korrespondierende Sensorsignale keine oder nur geringe stationäre Phasen auf. Entsprechend werden auch die digitalen Werte, die von dem Sensor bzw. einem nachgeschalteten A/D-Wandler ausgegeben werden, sich permanent ändern. In solchen Fällen ist daher keine längere Folge von gleichen oder zumindest annähernd gleichen Werten zu erwarten.

Die digitalen Daten der einzelnen Sensoren 10-i des Messsystems 1 werden zu einer zentralen Verarbeitungsvorrichtung 40 übertragen. Beispielsweise kann es sich bei der zentralen Verarbeitungsvorrichtung 40 um eine Verarbeitungsvorrichtung in einer Cloud oder ähnlichem handeln. Insbesondere wenn hierbei Sensordaten von einer großen Anzahl von Sensoren 10-i mit einer hohen Abtastrate und/oder Auflösung kontinuierlich an die zentrale Verarbeitungsvorrichtung 40 übertragen werden, kommt es dabei zu einer sehr großen Menge an zu übertragenden Sensordaten.

Zur Reduktion der übertragenen Datenmenge werden die Sensordaten der Sensoren 10-i daher komprimiert. Im Anschluss werden die komprimierten Sensordaten übertragen und in der Verarbeitungsvorrichtung 40 dekomprimiert.

Da es sich bei den von den Sensoren 10-i erfassten beschriebenen physikalischen Größen um Größen handeln kann, welche sich kontinuierlich verändern und dabei, wie oben beschrieben, gegebenenfalls keine längeren Phasen mit gleichen oder zumindest annähernd gleichen Werten erwartet werden können, sind hierfür konventionelle Kompressionsverfahren, welche eine Anzahl von gleichen Datenelementen in einer abgeschlossenen Datenmenge analysierten, für eine solche Kompression weniger geeignet und führen auch zu einer eher geringeren Kompressionsrate.

Auch sind Kompressionsverfahren, welche auf einer verlustbehafteten Kompression beruhen, für die Übertragung der Sensordaten nicht geeignet, da im Falle einer verlustbehafteten Kompression auf der Empfangsseite in der Verarbeitungsvorrichtung 40 nicht mehr die vollständigen originalen Sensordaten rekonstruiert werden können.

Erfindungsgemäß ist es daher vorgesehen, die von den Sensoren 10-i bereitgestellten digitalen Sensordaten in einer Vorrichtung 20-i zur Übertragung von Sensordaten mittels eines verlustfreien Kompressionsalgorithmus zu komprimieren, welcher für eine Kompression eines kontinuierlichen Datenstroms ausgelegt ist. Insbesondere können hierzu Kompressionsalgorithmen eingesetzt werden, welche für eine verlustfrei Komprimierung von Streaming-Daten bzw. von digitalen Audiosignalen eingesetzt werden. Derartige Kompressionsalgorithmen werden bisher größtenteils nur im Bereich der Übertragung von Mediendaten, beispielsweise für Audiodaten oder gegebenenfalls Videodaten eingesetzt.

Die Verwendung derartiger verlustfreier Kompressionsverfahren für die Übertragung von digitalen Sensordaten beruht dabei auf die Erkenntnis, dass die Sensordaten von sich kontinuierlich ändernden Signalen eine große Ähnlichkeit mit Streaming-Daten, insbesondere Audiodaten haben. Daher eignen sich derartige verlustfreie Kompressionsalgorithmen für Streaming- oder Audiodaten auch für einen effiziente Komprimierung entsprechender Sensordaten.

Die durch die Vorrichtung 20-i zur Übertragung von Sensordaten komprimierten Sensordaten können daraufhin in komprimierter Form zu der Verarbeitungsvorrichtung 40 übertragen werden.

Gegebenenfalls können in den Übertragungsweg von den Sensoren 10-i zu der Verarbeitungsvorrichtung 40 eine oder mehrere Aggregationseinrichtungen 30 vorgesehen sein. Diese Aggregationseinrichtungen 30 kann beispielsweise Datenströme von mehreren Sensoren 10-i empfangen und zu einem gemeinsamen Datenstrom kombinieren. Hierbei können, wie in Figur 1 dargestellt, die bereits komprimierten Datenströme der einzelnen Sensoren 10-i zusammengefasst werden. Alternativ können, wie nachfolgend noch beschrieben wird, auch zunächst die Datenströme der einzelnen Sensoren 10-i durch eine Aggregationseinrichtung 30 zusammengefasst werden und daraufhin dieser kombinierte Datenstrom durch eine Vorrichtung 20 zur Übertragung von Sensordaten komprimiert werden.

Die komprimierten Sensordaten werden, wie zuvor bereits beschrieben, in einer Verarbeitungsvorrichtung 40 empfangen. Hierzu kann in der Verarbeitungsvorrichtung 40 beispielsweise eine Empfangseinrichtung 41 vorgesehen sein. Beispielsweise können die empfangenen komprimierten Sensordaten in einer Speichereinrichtung 43 in komprimierter Form gespeichert werden.

Ferner ist in der Verarbeitungsvorrichtung 40 eine Dekomprimierungseinrichtung 42 vorgesehen. Diese Dekomprimierungseinrichtung 42 kann beispielsweise die empfangenen komprimierten Sensordaten direkt nach dem Empfang dekomprimieren bzw. entpacken. Zusätzlich oder alternativ kann die Dekomprimierungseinrichtung 42 auch die in der Speichereinrichtung 43 gespeicherten komprimierten Sensordaten auslesen und dekomprimieren.

Da für die Kompression und Dekompression ein verlustfreies Kompressionsverfahren eingesetzt wird, stehen somit auf der Empfangsseite in der Verarbeitungsvorrichtung 40 die ursprünglichen Sensordaten vollständig für eine Weiterverarbeitung zur Verfügung.

Figur 2 zeigt eine schematische Darstellung eines Blockschaubilds einer Vorrichtung 20 zur Übertragung von Sensordaten gemäß einer Ausführungsform. Wie in Figur 2 zu erkennen ist, kann die Vorrichtung 20 zur Übertragung der Sensordaten eine Komprimierungseinrichtung 21 umfassen. Diese Komprimierungseinrichtung 21 kann beispielsweise die Sensordaten von einem Sensor 10-i empfangen und komprimieren. Hierbei kann in der Komprimierungseinrichtung 21, wie zuvor bereits beschrieben, ein verlustfreier Kompressionsalgorithmus für einen Datenstrom verwendet werden, wie er zur Kompression von Streaming- oder Audiodaten eingesetzt wird.

Insbesondere eignen sich für die verlustfreie Kompression der Sensordaten beispielsweise verlustfrei AudioKompressionsverfahren, wie zum Beispiel Free Lossless Audio Codec (FLAC). Aber auch andere verlustfrei Kompressionsverfahren für Streaming Daten, insbesondere für Audiodaten sind möglich. Beispielsweise kann als verlustfreies Kompressionsverfahren auch Adaptive TRansform Acoustic Coding (ATRAC), MPEG-4 Audio Lossless Coding (ALS), MPEG-1 Audio Layer 3 (mp3HD) oder ein beliebiger andere verlustfrei Audio-Kompressionsalgorithmus verwendet werden.

Mit anderen Worten, die Komprimierungseinrichtung 21 verwendet für die Kompression der Sensordaten von den Sensoren 10-i einen Kompressionsalgorithmus, welcher ursprünglich für einen anderen Anwendungszweck entwickelt worden ist. Aufgrund der Erkenntnis, dass die Sensordaten in bestimmten Anwendungsfällen, wie beispielsweise bei der Überwachung von Strömen oder Leistungen werden, eine sehr große Ähnlichkeit mit Audiodaten aufweisen, kann auf diese Weise eine effiziente Kompression der Sensordaten mit einer hohen Kompressionsrate erreicht werden.

Im Anschluss an die Komprimierung der Sensordaten werden die komprimierten Sensordaten durch eine Übertragungseinrichtung 22 ausgegeben. Insbesondere kann eine Übertragung zu einer Verarbeitungsvorrichtung 40 erfolgen. Hierzu können beliebige geeignete Übertragungswege bzw. Übertragungsverfahren genutzt werden.

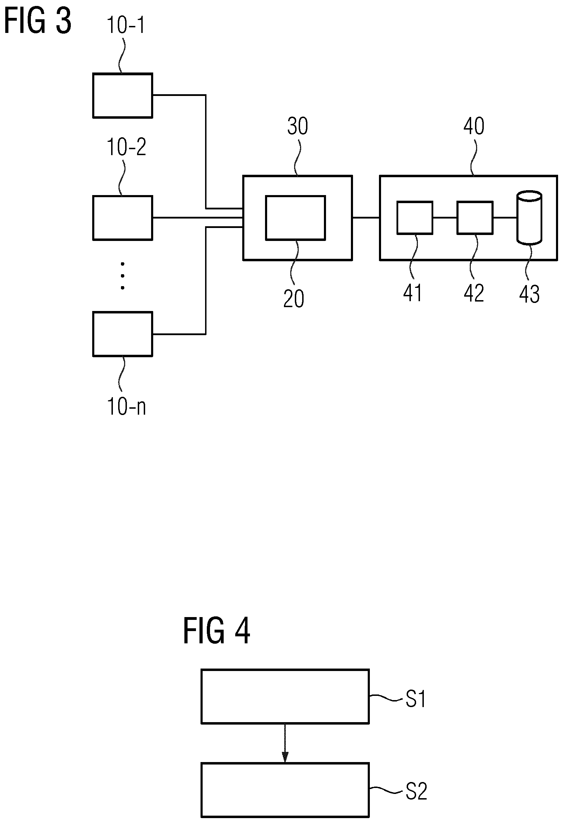

Figur 3 zeigt eine schematische Darstellung eines Blockschaubild eines Messsystems 1 gemäß einer weiteren Ausführungsform. Hierbei gelten, soweit anwendbar, sämtliche bereits zuvor gemachten Ausführungen.

Die Ausführungsform gemäß Figur 3 unterscheidet sich von der zuvor beschriebenen Ausführungsform gemäß Figur 1 insbesondere dadurch, dass die Sensordaten von den einzelnen Sensoren 10-i zunächst in unkomprimierter Form an einer Aggregationseinrichtung 30 bereitgestellt werden. Die Aggregationseinrichtung 30 kombiniert bzw. bündelt zunächst mehrere unkomprimierte Datenströme von mehreren Sensoren 10-i. Daraufhin erfolgt eine Komprimierung des gebündelten Datenstroms durch eine Komprimierungseinrichtung 21 in einer Vorrichtung 1 zur Übertragung von Sensordaten. Auch hierbei kann für die Komprimierung des gebündelten Datenstroms ein verlustfreier Kompressionsalgorithmus für Streaming- oder Audiodaten eingesetzt werden.

Der weitere Übertragungsweg sowie die Weiterverarbeitung der komprimierten Sensordaten erfolgt analog zu der Ausführungsform in Zusammenhang mit Figur 1.

Figur 4 zeigt ein Ablaufdiagramm, wie es einem Verfahren zur Übertragung von Sensordaten gemäß einer Ausführungsform zugrunde liegt. Das Verfahren kann grundsätzlich beliebige Schritte umfassen, wie sie zur Realisierung eines Verfahrens erforderlich sind, um den zuvor beschriebenen Ablauf in Zusammenhang mit Figur 1 bis 3 auszuführen. Analog können auch die zuvor beschriebenen Vorrichtungen beliebige Komponenten umfassen, um die nachfolgend beschriebenen Verfahrensschritte auszuführen.

In Schritt S1 erfolgt eine Kompression von Sensordaten von mindestens einem Sensor 10-i. Die Kompression erfolgt insbesondere unter Verwendung eines verlustfrei Kompressionsalgorithmus. Dieser verlustfrei Kompressionsalgorithmus ist insbesondere dazu ausgelegt, einen kontinuierlichen Datenstroms verlustfrei zu komprimieren. Wie beschrieben, kann es sich bei diesen verlustfreien Kompressionsalgorithmen beispielsweise um einen Kompressionsalgorithmus für Streaming- oder Audiodaten handeln.

In Schritt S2 werden daraufhin die komprimierten Sensordaten ausgegeben.

Zusammenfassend betrifft die vorliegende Erfindung eine Kompression zur Übertragung von Sensordaten, insbesondere von Sensordaten für sich kontinuierlich ändernde Sensorwerte. Hierzu wird vorgeschlagen, für die Kompression der Sensordaten einen verlustfreien Kompressionsalgorithmus aus dem Bereich der Streaming- oder Audiosignale einzusetzen.

## Patentansprüche

1. Vorrichtung (20) zur Übertragung von Sensordaten, mit:
einer Komprimierungseinrichtung (21), die dazu ausgelegt ist, die Sensordaten von mindestens einem Sensor (10-i) unter Verwendung eines verlustfreien Kompressionsalgorithmus zu komprimieren; und
einer Übertragungseinrichtung (22), die dazu ausgelegt ist, die komprimierten Sensordaten auszugeben,
wobei der verlustfreie Kompressionsalgorithmus dazu ausgelegt ist, einen kontinuierlichen Datenstrom verlustfrei zu komprimieren.

2. Vorrichtung (20) nach Anspruch 1, wobei der Kompressionsalgorithmus einen Algorithmus zur verlustfreien Kompression von Audio- oder Streaming-Daten umfasst.

3. Vorrichtung (20) nach Anspruch 1 oder 2, wobei der Kompressionsalgorithmus einen Free Lossless Audio Codec, FLAC, umfasst.

4. Vorrichtung (40) zur Verarbeitung von komprimierten Sensordaten, mit:
einer Dekomprimierungseinrichtung (42), die dazu ausgelegt ist, verlustfrei komprimierte Sensordaten von mindestens einem Sensor (10-i) unter Verwendung eines verlustfreien Dekompressionsalgorithmus zu dekomprimieren,
wobei der Dekompressionsalgorithmus dazu ausgelegt ist, Daten aus einen verlustfrei komprimierten kontinuierlichen Datenstrom zu dekomprimieren.

5. Vorrichtung (40) nach Anspruch 4, mit einer Empfangseinrichtung (41), die dazu ausgelegt ist, verlustfrei komprimierte Sensordaten von mindestens einem Sensor (10-i) zu empfangen; und
einer Speichereinrichtung (43), die dazu ausgelegt ist, die empfangenen verlustfrei komprimierten Sensordaten zu speichern,
wobei die Dekomprimierungseinrichtung (42) dazu ausgelegt ist, die gespeicherten komprimierten Sensordaten zu dekomprimieren.

6. Vorrichtung (40) nach Anspruch 4 oder 5, mit einer Verarbeitungseinrichtung, die dazu ausgelegt ist, die dekomprimierten Sensordaten zu verarbeiten.

7. Vorrichtung nach einem der Ansprüche 4 bis 6, wobei der Kompressionsalgorithmus einen Algorithmus zur verlustfreien Kompression von Audio- oder Streaming-Daten umfasst.

8. Messsystem (1), mit:
mindestens einem Sensor (10-i), der dazu ausgelegt ist, Sensordaten bereitzustellen, die zu einer sensorisch erfassten physikalischen Größe korrespondieren; und
einer Vorrichtung (20) zur Übertragung von Sensordaten nach einem der Ansprüche 1 bis 3.

9. Messsystem (1) nach Anspruch 8, mit einer Vorrichtung (40) zur Verarbeitung von komprimierten Sensordaten nach einem der Ansprüche 4 bis 7.

10. Messsystem (1) nach Anspruch 8 oder 9, wobei der mindestens eine Sensor (10-i) dazu ausgelegt ist, einen elektrischen Strom oder eine elektrische Leistung zu erfassen.

11. Messsystem (1) nach einem der Ansprüche 8 bis 10, wobei der mindestens eine Sensor (10-i) dazu ausgelegt ist, die physikalische Grüße mit einer Abtastrate von mindesten 1 Kilohertz abzutasten.

12. Messsystem (1) nach einem der Ansprüche 8 bis 11, mit einer Aggregationseinrichtung (30), die dazu ausgelegt ist, mehrere komprimierte Datenströme zu einem gemeinsamen Datenstrom zu bündeln und weiterzuleiten.

13. Verfahren zur Übertragung von Sensordaten, mit den Schritten:
Komprimieren (S1) von Sensordaten von mindestens einem Sensor (10-i) unter Verwendung eines verlustfreien Kompressionsalgorithmus; und
Ausgeben (S2) der komprimierten Sensordaten,
wobei der verlustfreie Kompressionsalgorithmus dazu ausgelegt ist, einen kontinuierlichen Datenstrom verlustfrei zu komprimieren.

14. Verfahren nach Anspruch 13, wobei der Kompressionsalgorithmus einen Algorithmus zur verlustfreien Kompression von Audio- oder Streaming-Daten umfasst.
